# EUROPEAN PATENT SPECIFICATION

(11) **EP 2 822 242 B1**
(45) Date of publication and mention of the grant of the patent: **27.04.2016**
(21) Application number: 12870172.9
(22) Date of filing: 19.06.2012
(51) Int. Cl.: H03F 3/24, H04B 1/04, H04L 25/02, H04L 27/36, H04B 17/13, H03F 1/32

(54) **DIGITAL PREDISTORTION PROCESSING METHOD AND DEVICE**
VERFAHREN UND VORRICHTUNG ZUR VERARBEITUNG EINER DIGITALEN VORVERZERRUNG
PROCÉDÉ ET DISPOSITIF DE TRAITEMENT DE LA PRÉDISTORSION NUMÉRIQUE

(30) Priority: 28.02.2012 CN 201210047501
(43) Date of publication of application: 07.01.2015
(73) Proprietor: ZTE Corporation, Shenzhen, Guangdong 518057 (CN)
(72) Inventor: WANG, Lin, Shenzhen Guangdong 518057 (CN); WANG, Peng, Shenzhen Guangdong 518057 (CN); LEI, Hong, Shenzhen Guangdong 518057 (CN)
(74) Representative: Swindell & Pearson Limited
(86) International application number: PCT/CN2012/077131
(87) International publication number: WO 2013/127141

(56) References cited:
- WO-A1-2010/112364
- WO-A1-2011/097844
- CN-A- 101 056 128
- CN-A- 102 014 090

## Description

### Technical Field

The present invention relates to the field of digital signal processing, and in particular, to a digital predistortion processing method and device.

### Background Art

With the development of mobile communication technology, the number of the users and traffics of mobile communication increase dramatically, and spectrum resources are more and more scarce. In order to improve the utilization ratio of the spectrum, a highly-efficient modulation mode is generally adopted, therefore, the requirement on the power amplifier used by a base station becomes higher and higher. With the demand that the power amplifier meets the degree of linearity, it is required to improve the efficiency of the power amplifier and reduce its power consumption. Therefore, the problem of power amplifier distortion cannot be solved by the power back-off method. In the existing various power amplifier linearity technologies, digital predistortion has drawn wide attention due to its advantages such as good adaptability, wide frequency band, low costs and good correction effect, and has become the primary selection for non-linear system correction.

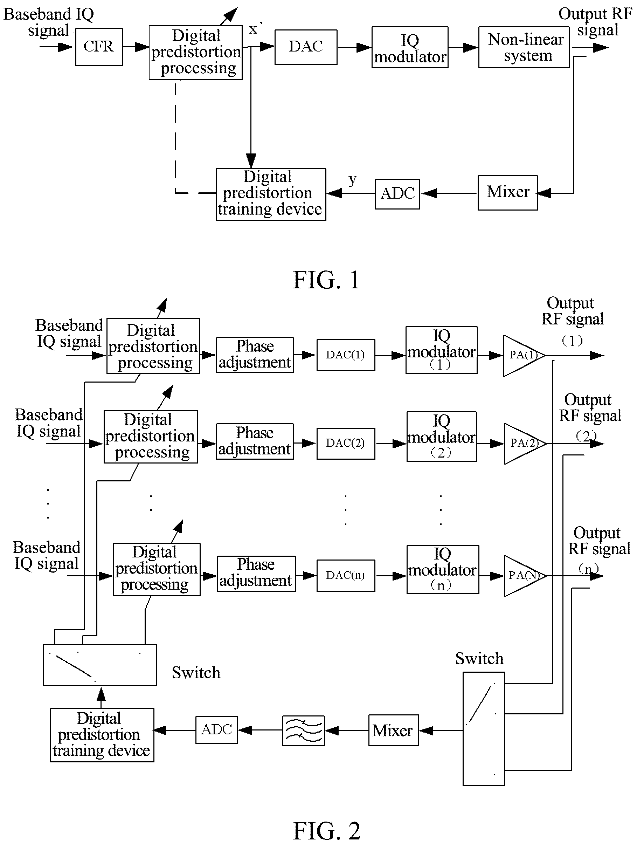

Fig. 1 shows the typical structure of a single-channel digital predistortion processing device currently used, and its working principle and process is that: a digital predistortion training device performs comparison calculation on an input baseband IQ signal and a fed-back coupled digital signal collected by ADC to obtain predistortion correction parameters to be used by a digital predistorter for performing digital predistortion processing, the signal after predistortion processing is output to a DAC to be converted into an analog signal, and the analog signal is amplified and output by a mixer amplifier. The fed-back coupled signal is precisely from the amplifier here and is output to pass through a mixer and ADC and is then sent to the digital predistortion training device.

The above traditional digital predistortion processing device may be composed of a programmable gate array (FPGA), a DAC, a mixer, a DSP, a filter and an ADC. The device performs up-conversion peak clipping processing on the baseband IQ signal, and then the digital signal after peak clipping is sent to a digital predistorter for predistortion processing. A feedback link couples and feeds back the analog signal of the baseband IQ signal obtained after conversion and amplification, and the radio frequency signal coupled back is converted into a medium frequency signal through analog down-conversion and filtering, and then is converted into a digital signal through ADC to input into the digital predistortion training device to be compared with the baseband IQ signal to obtain predistortion correction parameters, and then the predistortion correction parameters are used for the digital predistorter.

As for a single-channel single-power amplifier system, the above traditional digital predistortion processing device is acceptable in terms of cost and application, however, with the development of active antenna technology and increase of the number of radio frequency channels, a digital predistorter and a feedback link need to be added to each emission channel if the above traditional DPD device is used. The volume, cost, power consumption and link complexity will all increase dramatically as the number of channels increases.

In view of the above problems, there are currently some literatures making study and analysis on them. The main study results and processing methods are that: channel switching control is performed using a channel selection signal, predistortion training is performed on the collected forward digital signal and the output digital signal coupled back by the power amplifier, a synchronous control signal in the channel selection signal controls an output of the power amplifier, and the obtained predistortion correction parameters are used for the corresponding digital predistorter, as recorded in the description of Chinese patent CN200810044447.3.

Fig. 2 illustrates the structure of a digital predistortion processing device in an existing multi-channel system. As for the baseband IQ signal of each channel of the device, each path has a digital predistorter for completing digital predistortion processing, a feedback channel is shared, a radio frequency switch is used for switching, the baseband IQ signal in the corresponding channel and the feedback signal are collected, each channel is subjected to DPD training in rotation, and the extracted predistortion correction parameters are downloaded to the corresponding digital predistorter for performing predistortion processing.

However, since one feedback channel and one digital predistortion training device are shared, and a rotational training mode is used, the training speed will become slower and the cycle period will become longer as the number of channels increase, therefore, the correction efficiency is not high enough, which cannot meet the requirement for real-time correction; moreover, the requirement on the resources is also very high if one channel has one digital predistorter.

### Summary of the Invention

The technical problem to be solved by the examples of the present invention is to provide a digital predistortion processing method and device, which can be adapted to a single-channel multi-power amplifier system.

In order to solve the above technical problem, an example of the present invention provides a digital predistortion processing method, comprising:
performing digital predistortion processing on a baseband signal according to a predistortion correction parameter, converting the baseband signal after the digital predistortion processing into a radio-frequency signal, power dividing the radio-frequency signal, and respectively outputting each path of the radio-frequency signal to a distinct power amplifier;
coupling and outputting the radio-frequency signal output by each power amplifier to a feedback link for combination to obtain a combined signal, and performing conversion processing on the combined signal;, and
generating a predistortion correction parameter according to the combined signal after the conversion processing and the baseband signal before the digital predistortion processing, and updating the predistortion correction parameter.

Optionally, the step of generating a predistortion correction parameter according to the combined signal after the conversion processing and the baseband signal before the digital predistortion processing comprises:
processing the combined signal and the baseband signal before the digital predistortion processing to eliminate differences between the combined signal and the baseband signal in delay, amplitude phase, energy and frequency offset, and obtaining an aligned combined signal and the baseband signal before the digital predistortion processing;
performing comparison calculation on the aligned combined signal and the baseband signal before the digital predistortion processing to generate the predistortion correction parameter.

Optionally, the step of performing conversion processing on the combined signal comprises:
down-converting the combined signal into a medium frequency signal, and filtering the medium frequency signal, and converting the filtered combined signal into a digital signal, obtaining the combined signal after the conversion processing.

Optionally, the step of dividing the radio-frequency signal comprises:
dividing the radio frequency signal into N(N> 1) paths of same radio frequency signal using a power divider.

Optionally, the step of converting the baseband signal into a radio frequency signal comprises:
performing digital-to-analogue conversion on the baseband signal after the digital predistortion processing to obtain an analog signal, and modulating the analog signal into a radio frequency signal through orthogonal modulation.

Optionally, a digital predistortion processing device, comprises: a digital predistortion processor, a baseband signal conversion circuit, a power divider, a power amplifier, a combiner, a combined signal processing circuit and a digital predistortion training device, wherein:
the digital predistortion processor is configured to perform digital predistortion processing on a baseband signal according to a predistortion correction parameter, and transmit the baseband signal after the digital predistortion processing to the baseband signal conversion circuit;
the baseband signal conversion circuit is configured to convert the baseband signal after the digital predistortion processing into a radio frequency signal, and transmit the radio frequency signal to the power divider;
the power divider is configured to divide the radio frequency signal, and respectively transmit each path of radio frequency signal to a distinct power amplifier;
the combiner is configured to couple and output the radio frequency signal output by each power amplifier to a feedback link for combination to obtain a combined signal, and transmit the combined signal to the combined signal processing circuit;
the combined signal processing circuit is configured to perform conversion processing on the combined signal, and transmit the combined signal after the conversion processing to the digital predistortion training device;
the digital predistortion training device is configured to generate a predistortion correction parameter according to the combined signal after the conversion processing and the baseband signal before the digital predistortion processing, and update the predistortion correction parameter to the digital predistortion processor.

Optionally, the digital predistortion training device comprises: a data collecting module, a data processing module, a predistortion correction parameter extraction module and a parameter update module, wherein:
the data collecting module is configured to collect the combined signal and the baseband signal before the digital predistortion processing;
the data processing module is configured to process the combined signal and the baseband signal before the digital predistortion processing to eliminate differences between the combined signal and the baseband signal in delay, amplitude phase, energy and frequency offset, and obtaining an aligned combined signal and the baseband signal before the digital predistortion processing;
the predistortion correction parameter extraction module is configured to perform comparison calculation on the aligned combined signal and the baseband signal before the digital predistortion processing to generate the predistortion correction parameter;
the parameter updating module is configured to update the predistortion correction parameter to the digital predistortion processor.

Optionally, the combined signal processing circuit comprises: a mixer, a filter and an analog-digital converter, wherein:
the mixer is configured to down-convert the combined signal into a medium frequency signal, and transmit the medium frequency signal to the filter;
the filter is configured to filter the medium frequency signal, and transmit a filtered combined signal to the analog-digital converter;
the analog-digital converter is configured to convert the filtered combined signal into a digital signal, obtaining the combined signal after the conversion processing.

Optionally, the power divider is configured to divide the radio frequency signal into N(N> 1) paths of same radio frequency signal.

Optionally, the baseband signal conversion circuit comprises: a digital-to-analogue converter and a modulator, wherein:
the digital-to-analogue converter is configured to perform digital-to-analogue conversion on the baseband signal after the digital predistortion processing to obtain an analog signal, and transmit the analog signal to the modulator;
the modulator is configured to modulate the analog signal into a radio frequency signal through orthogonal modulation.

In conclusion, as for a single-channel multi-power amplifier system, the example of the present invention provides a digital predistortion processing method and device applied in the single-channel multi-power amplifier system, which reduces the link complexity, saves link costs and resources, and meanwhile improves digital predistortion efficiency.

### Brief Description of Drawings

Fig. 1 illustrates the structure of an existing typical single-channel digital predistortion processing device;
Fig. 2 illustrates the structure of an existing multi-channel shared-feedback link digital predistortion processing device;
Fig. 3 is a flowchart of a single-channel multi-power amplifier digital predistortion processing method according to the present invention;
Fig. 4 illustrates the structure of a single-channel multi-power amplifier digital predistortion processing device according to the present invention;
Fig. 5 illustrates the structure of the composition of a non-linear system according to the present invention.

### Preferred Embodiments of the Invention

The digital predistortion processing device according to this embodiment is applied in a single-channel multi-power amplifier system, comprising: a digital predistortion processor, a digital-to-analog converter, an IQ modulator, a power divider, a combiner, a mixer, an analog-to-digital converter, a filter and a digital predistortion processing training device, and so on. The digital predistortion processing method according to this embodiment comprises: outputting a baseband IQ (orthogonal) signal and a feedback signal of a radio frequency signal obtained from conversion of the baseband IQ signal into a digital predistortion training device, performing processing and comparison calculation to generate a predistortion correction parameter, transmitting the predistortion correction parameter to the digital predistortion processor for performing predistortion processing on the baseband IQ signal.

The power divider is placed at the front end of the power amplifier and after the IQ modulator for dividing a radio frequency signal into N(N>1) paths of same radio frequency signal, which are correspondingly output to each power amplifier, wherein N is the number of power amplifiers.

The combiner is located in the feedback link for combining and superimposing radio frequency signals coupled back from multiple power amplifier output ports, and outputting a combined signal. The combiner directly receives the radio frequency signals coupled back, and the output combine signal is output to the mixer.

The input of the mixer is connected with the output of the combiner, and mixing is performed on the input combined signal to down-convert it into a medium frequency signal to output.

The filter is a band-pass filter which filters out useless signals, its input is the medium frequency signal input by the mixer, and its output is transmitted to the analog-to-digital converter. The center frequency point of the filter is the same with the emission medium frequency point (the frequency point of the medium frequency signal), and the bandwidth is the whole bandwidth including third-order intermodulation and fifth-order intermodulation.

The analog-to-digital converter is used for converting an analog signal into a digital signal.

The digital predistortion processor completes collection of the forward baseband IQ signal (the baseband signal before the digital predistortion processing) and the combined signal, and transmits the combined signal and forward baseband IQ signal to the digital predistortion training device, the digital predistortion training device uses the combined signal and forward baseband IQ signal transmitted by the digital predistortion processor to generate a predistortion correction parameter. The digital predistortion processor performs digital predistortion processing on the baseband IQ signal according to the predistortion correction parameter generated by the digital predistortion training device, and sends the signal after the predistortion processing to the non-linear system.

The digital predistortion training device performs data processing and comparison calculation on the combined signal and the baseband signal before the digital predistortion processing to generate a predistortion correction parameter. One end of the digital predistortion training device is connected with the baseband IQ signal end, and at this end, there is the baseband IQ signal before digital predistortion processing and after up-conversion and CPR (peak clipping), and the data rate is 184.32; the other end is connected with the ADC output port in the feedback link.

The digital predistortion training device comprises: a data checking module, a data processing module, a predistortion parameter extraction module and a parameter downloading module.

The data checking module performs data checking on the forward IQ signal and combined signal that is fed back, and ensures the validity and correctness of the sample data.

The data processing module performs data processing on the sample data, and sends the processed data to the predistortion parameter extraction module to generate the predistortion correction parameter, and data processing comprises data alignment, for example, alignment of time delay, amplitude, phase and so on.

The parameter downloading module downloads the generated predistortion correction parameter to the digital predistortion processor for performing digital predistortion processing of the link.

The digital predistortion processing method according to this embodiment comprises:
step one, dividing the radio frequency signal of the front end of the power amplifier into N paths of radio frequency signal, wherein N is the number of corresponding power amplifiers, and outputting each path of radio frequency signal to the corresponding power amplifier;
step two, coupling each path of radio frequency signal to the combiner of the feedback link, and the combiner combining and superimposing all paths of radio frequency signal into one path of signal (combined signal);
step three, performing mixing on the combined signal to down-convert it into a medium frequency analog signal;
step four, performing band-pass filtering on the medium frequency signal, and filtering out useless signals;
step five, inputting the signal after the frequency conversion and filtering into the analog-to-digital converter, and converting the analog signal into a digital signal;
step six, the digital predistortion training device generating the predistortion correction parameter according to the baseband IQ signal and the combined signal that is fed back, and downloading it to the digital predistortion

The digital predistortion training device generates the predistortion correction parameter by the following steps:
(1) collecting data
(2) preprocessing data
(3) generating the predistortion correction parameter
(4) downloading and updating the predistortion correction parameter

What is described above is the process of generating the predistortion correction parameter. The digital predistortion training device updates the trained predistortion correction parameter to the digital predistortion processor, the baseband IQ signal enters the digital predistortion processor after up-conversion and peak clipping, digital predistortion processing is performed on the baseband IQ signal, and the signal after predistortion is sent to the non-linear system, the radio frequency signal output at this moment after correction meets the requirement of the system.

The above non-linear system is not used to indicate one power amplifier or a certain non-linear device, but it indicates an integrated non-linear model, which is a superimposition of N power amplifiers, that is, one non-linear model is used to replace N non-linear models. Neither the feature of each non-linear model nor the digital predistortion effect of each non-linear model is a concern here, but it is regarded as a whole, the non-linearity feature of the whole non-linear system is extracted for performing digital predistortion so that the output of the whole system meets the index performance requirement of the system.

The digital predistortion processing device of the present document is adapted to a single-channel multi-power amplifier system, and is very practical for the existing active antenna system. In order to implement the beamforming function of the active antenna, the output of the power amplifier (PA) of the above system is connected to an analog phase shifter, which can be used for beamforming of the active antenna. The feedback coupling point is at the power amplifier, and a feedback signal is coupled from the rear end of the power amplifier and the front end of the analog phase shifter for digital predistortion training, thus, the adjustment of the phase shifter may not be introduced into the digital predistortion training, which will not affect the beamforming effect of the active antenna.

In the prior art, it all relates to the digital predistortion device of a multi-channel multi-power amplifier or multi-channel single-power amplifier system. The existing active antenna system is a single-channel multi-power amplifier system, and the baseband is not divided into multiple paths. If the multi-channel digital predistortion system mentioned in the Background Art is adopted, the baseband is divided into N paths before the digital predistortion, N paths of analog link are connected to the power amplifiers, and then the scheme of shared feedback is used, which is a waste of radio frequency links, and it is also not real multiple-channel.

This embodiments provides a model of combined digital predistortion for the single-channel multi-power amplifier system, wherein a concept of replacing N non-linear systems with one non-linear system is adopted, the design of the whole radio frequency link is simplified, only one channel is needed and it is divide into N paths at the front ends of the power amplifiers and output to N power amplifiers, the feedback data of all power amplifiers are collected for combination, the digital predistortion training device extracts the predistortion parameter according to the combined signal and the forward baseband IQ signal. This scheme is easy to implement, the iteration efficiency of digital predistortion is high, and the output can meet the ACLR requirement of the system.

The embodiments of the present invention will be described in detail below with reference to the drawings and examples, whereby the implementation process that how the present invention uses the technical means to solve the technical problem and achieve the technical effect can be sufficiently appreciated and implemented.

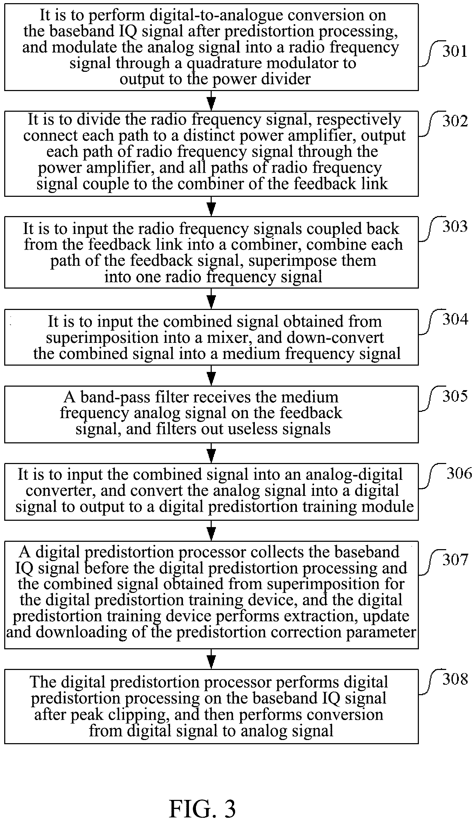

As shown in Fig. 3, the digital predistortion processing method for a single-channel multi-power amplifier system according to the present embodiment comprises the following steps:
In Step 301, it is to perform digital-to-analogue conversion on the baseband IQ signal after predistortion processing through a DAC module, and modulate the analog signal into a radio frequency signal through a quadrature modulator to output to the power divider;
In Step 302, it is to divide the radio frequency signal at the front end of the power amplifier through a power divider, respectively connect each path to a distinct power amplifier, output each path of radio frequency signal through the power amplifier, and all paths of radio frequency signal couple to the combiner of the feedback link, wherein, the power divider is divided into N paths connected with different power amplifiers, N is determined by the number of the power amplifiers;
In Step 303, it is to collectively input the radio frequency signals coupled back from the feedback link into a combiner, combine each path of the feedback signal, superimpose them into one radio frequency signal (a combined signal), thereby obtaining a feedback signal collectively corresponding to the forward IQ signal;
In Step 304, it is to input the combined signal obtained from superimposition into a mixer, down-convert the combined signal into a medium frequency signal, the local oscillator signal required by the mixer is provided by an external local oscillator signal of homologous reference;
In Step 305, a band-pass filter receives the medium frequency analog signal on the feedback link, and filters out useless signals;
In Step 306, it is to input the combined signal after frequency conversion and filtering processing into an analog-digital converter, and convert the analog signal into a digital signal to output to a digital predistortion training module;
In Step 307, a digital predistortion processor collects the baseband IQ signal before the digital predistortion processing and the combined signal obtained from superimposition for the digital predistortion training device, and the digital predistortion training device performs extraction, update and downloading of the predistortion correction parameter;

The processing flows of the specific functions contained in the digital predistortion training device are as below:
(1) a data collecting module is used to provide the requirement for collecting data, and initiate collecting the baseband IQ signal and the combined signal that is fee back;
(2) a data checking module is used to check the validity and correctness of the collected baseband IQ signal and the fed back combined signal so as to ensure the validity of the digital predistortion processing, it must be ensured that the signal is large enough to reflect the feature of the signal correctly and completely, while the data can not be overlarge to result in signal overflow and distortion, in which case the feature of the signal cannot be correctly reflected either.
(3) with the premise of ignoring the influence of distortion feature of the whole link, the collected IQ signal differs from the fed back combined signal in time delay, amplitude phase, energy and frequency offset, a data processing module is used to eliminate the differences in time delay, amplitude phase, energy and frequency offset; the frequency offset of the system here is fixed, and a fixed value is used for feedback demodulation;
(4) a predistortion correction parameter extraction module is used to perform comparison calculation on the aligned baseband signal and the fed back combined signal, and extracts a predistortion correction parameter;
(5) a parameter update module is used to download and update the extracted predistortion correction parameter to a digital predistortion processor;

In Step 308, the digital predistortion processor performs digital predistortion processing on the baseband IQ signal after peak clipping, and then performs conversion from digital signal to analog signal, at this time, it is to return to step 301.

The above flow is a flow of the whole digital predistortion processing. It can be seen that the digital predistortion training device implements control on data collecting, processing on the collected baseband signal and feedback signal, and extraction and update functions of the digital predistortion parameter, while the digital predistortion processor implements collection of data and digital predistortion processing on the baseband signal. It should be appreciated that the digital predistortion training device does not directly use the combined signal transmitted by the analog-digital converter, but obtains the combined signal and the forward baseband IQ signal from the digital predistortion processor to perform extraction of the predistortion correction parameter.

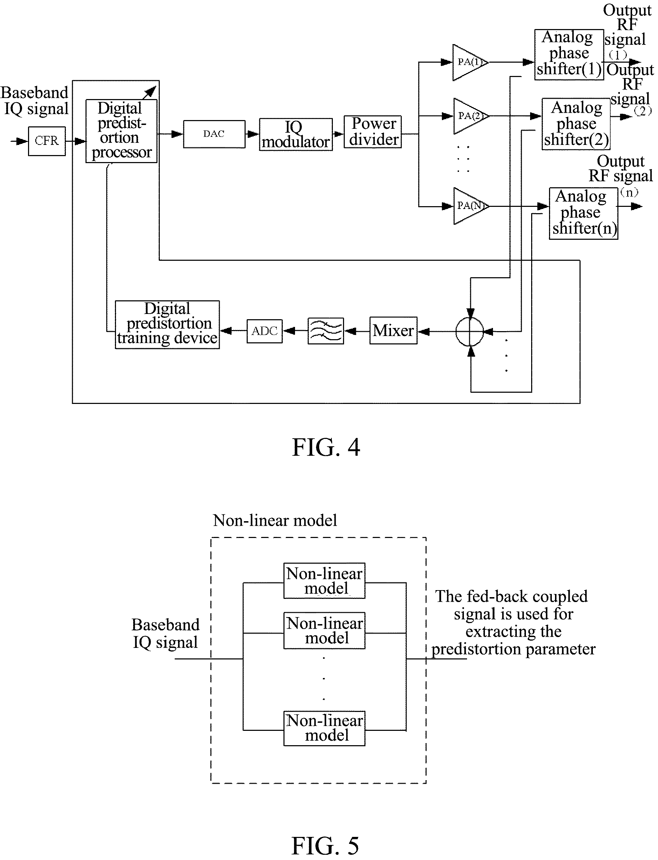

As shown in Fig. 4, the digital predistortion processing device according to this embodiment comprises: a digital predistortion processor, a baseband signal conversion circuit, a power divider, a power amplifier (PA), a combiner, a combined signal processing circuit and a digital predistortion training device, wherein:
the digital predistortion processor is configured to perform digital predistortion processing on a baseband signal according to a predistortion correction parameter, and transmit the baseband signal after the digital predistortion processing to the baseband signal conversion circuit;
the baseband signal conversion circuit is configured to convert the baseband signal after the digital predistortion processing into a radio frequency signal, and transmit the radio frequency signal to the power divider;
the power divider is configured to divide the radio frequency signal, and respectively transmit each path of radio frequency signal to a distinct power amplifier;
the combiner is configured to couple and output the radio frequency signal output by each power amplifier to a feedback link for combination to obtain a combined signal, and transmit the combined signal to the combined signal processing circuit;
the combined signal processing circuit is configured to perform conversion processing on the combined signal, and transmit the combined signal after the conversion processing to the digital predistortion training device;
the digital predistortion training device is configured to generate a predistortion correction parameter according to the combined signal after the conversion processing and the baseband signal before the digital predistortion processing, and update the predistortion correction parameter to the digital predistortion processor.

The digital predistortion training device extracts the predistortion correction parameter according to the combined signal and the forward baseband IQ signal obtained from the digital predistortion processor.

The digital predistortion training device comprises: a data collecting module, a data processing module, a predistortion correction parameter extraction module and a parameter update module, wherein:
the data collecting module is configured to collect the combined signal and the baseband signal before the digital predistortion processing;
the data processing module is configured to process the combined signal and the baseband signal before the digital predistortion processing to eliminate differences between the combined signal and the baseband signal in delay, amplitude phase, energy and frequency offset, and obtaining an aligned combined signal and baseband signal before the digital predistortion processing;
the predistortion correction parameter extraction module is configured to perform comparison calculation on the aligned combined signal and baseband signal before the digital predistortion processing to generate the predistortion correction parameter;
the parameter updating module is configured to update the predistortion correction parameter to the digital predistortion processor.

The combined signal processing circuit comprises: a mixer, a filter and an analog-digital converter, wherein:
the mixer is configured to down-convert the combined signal into a medium frequency signal, and transmit the medium frequency signal to the filter;
the filter is configured to filter the medium frequency signal, and transmit a filtered combined signal to the analog-digital converter;
the analog-digital converter is configured to convert the filtered combined signal into a digital signal, obtaining the combined signal after the conversion processing.

The power divider is configured to divide the radio frequency signal into N(N> 1) paths of same radio frequency signal.

The baseband signal conversion circuit comprises: a digital-to-analogue converter and a modulator, wherein:
the digital-to-analogue converter is configured to perform digital-to-analogue conversion on the baseband signal after the digital predistortion processing to obtain an analog signal, and transmit the analog signal to the modulator;
the modulator is configured to modulate the analog signal into a radio frequency signal through orthogonal modulation. The modulator in this embodiment adopts an IQ modulator.

Fig. 5 illustrates the composition structure of the non-linear system according to this embodiment. It can be seen that a concept of combination is adopted in this embodiment, various non-linear systems are combined together and collectively deemed as a large non-linear system, and digital predistortion processing is collectively performed. Herein, the correction of each path of non-linear system will not meet the requirement, but the correction of the whole non-linear system can meet the requirement of the system, because the extracted feature is a feature of the combination of various non-linear systems, and does not meet each non-linear system. By doing so, links can be saved, costs and space can be saved, and as for the digital predistortion, the predistortion iteration efficiency and the correction speed of the whole system can be improved.

In specific implementation applications, the method can be suitably expanded. When the number of channels increases, in the case of multiple power amplifiers, for example, as for an active antenna system of two channels, the present device can be applied to two channels respectively, and the method of shared feedback channel shown in Fig. 2 can be used, a switch is used to perform switching after feedback combination, each path is subjected to digital predistortion training respectively, which can efficiently improve the digital predistortion efficiency.

A person having ordinary skill in the art can appreciate that all of part of the steps of the above method may be implemented by instructing related hardware with a program, which may be stored in a computer-readable medium, such as a read-only memory, a magnetic disk or an optical disk. Optionally, all of part of the steps of the above examples may also be implemented by using one or more integrated circuits. Correspondingly, each module/unit in the above examples may be implemented in the form of hardware, or in the form of software functional modules. The present invention is not limited to any particular form of combination of hardware and software.

The above examples are only preferred examples of the present invention, and are not used to limit the protection scope of the present invention. Any modification, equivalent substitution and improvement made within the spirit and principle of the present invention should be within the protection scope of the present invention.

### Industrial Applicability

As for a single-channel multi-power amplifier system, the example of the present invention provides a digital predistortion processing method and device to be applied in the single-channel multi-power amplifier system, which reduces the link complexity, saves link costs and resources, and meanwhile improves digital predistortion efficiency.

## Claims

1. A digital predistortion processing method, comprising:
performing digital predistortion processing on a baseband signal according to a first predistortion correction parameter, converting the baseband signal after the digital predistortion processing into a radio-frequency signal, power dividing the radio-frequency signal, and respectively outputting each path of the radio-frequency signal to a distinct power amplifier;
coupling and outputting the radio-frequency signal output by each power amplifier to a feedback link for combination to obtain a combined signal, and performing conversion processing on the combined signal; and
generating a second predistortion correction parameter according to the combined signal after the conversion processing and the baseband signal before the digital predistortion processing, and updating the first predistortion correction parameter as the second predistortion correction parameter.

2. The method according to claim 1, wherein, the step of generating a second predistortion correction parameter according to the combined signal after the conversion processing and the baseband signal before the digital predistortion processing comprises:
processing the combined signal and the baseband signal before the digital predistortion processing to eliminate differences between the combined signal and the baseband signal in delay, amplitude phase, energy and frequency offset, and obtaining an aligned combined signal and the baseband signal before the digital predistortion processing;
performing comparison calculation on the aligned combined signal and the baseband signal before the digital predistortion processing to obtain the second predistortion correction parameter.

3. The method according to claim 1, wherein, the step of performing conversion processing on the combined signal comprises:
down-converting the combined signal into a medium frequency signal, and filtering the medium frequency signal, and converting a filtered combined signal into a digital signal, obtaining the combined signal after the conversion processing.

4. The method according to claim 1, wherein, the step of dividing the radio-frequency signal comprises:
dividing the radio frequency signal into N paths of same radio frequency signal using a power divider, wherein N is an integer greater than 1.

5. The method according to claim 1, wherein, the step of converting the baseband signal into a radio frequency signal comprises:
performing digital-to-analogue conversion on the baseband signal after the digital predistortion processing to obtain an analog signal, and modulating the analog signal into a radio frequency signal through orthogonal modulation.

6. A digital predistortion processing device, comprising: a digital predistortion processor, a baseband signal conversion circuit, a power divider, a power amplifier, a combiner, a combined signal processing circuit and a digital predistortion training device, wherein:
the digital predistortion processor is configured to perform digital predistortion processing on a baseband signal according to a first predistortion correction parameter, and transmit the baseband signal after the digital predistortion processing to the baseband signal conversion circuit;
the baseband signal conversion circuit is configured to convert the baseband signal after the digital predistortion processing into a radio frequency signal, and transmit the radio frequency signal to the power divider;
the power divider is configured to divide the radio frequency signal, and respectively transmit each path of radio frequency signal to a distinct power amplifier;
the combiner is configured to couple and output the radio frequency signal output by each power amplifier to a feedback link for combination to obtain a combined signal, and transmit the combined signal to the combined signal processing circuit;
the combined signal processing circuit is configured to perform conversion processing on the combined signal, and transmit the combined signal after the conversion processing to the digital predistortion training device;
the digital predistortion training device is configured to generate a second predistortion correction parameter according to the combined signal after the conversion processing and the baseband signal before the digital predistortion processing, and update the second predistortion correction parameter to the digital predistortion processor.

7. The device according to claim 6, wherein, the digital predistortion training device comprises: a data collecting module, a data processing module, a predistortion correction parameter extraction module and a parameter update module, wherein:
the data collecting module is configured to collect the combined signal and the baseband signal before the digital predistortion processing;
the data processing module is configured to process the combined signal and the baseband signal before the digital predistortion processing to eliminate differences between the combined signal and the baseband signal in delay, amplitude phase, energy and frequency offset, and obtaining an aligned combined signal and the baseband signal before the digital predistortion processing;
the predistortion correction parameter extraction module is configured to perform comparison calculation on the aligned combined signal and the baseband signal before the digital predistortion processing to generate the second predistortion correction parameter;
the parameter updating module is configured to update the second predistortion correction parameter to the digital predistortion processor.

8. The device according to claim 6, wherein, the combined signal processing circuit comprises: a mixer, a filter and an analog-digital converter, wherein:
the mixer is configured to down-convert the combined signal into a medium frequency signal, and transmit the medium frequency signal to the filter;
the filter is configured to filter the medium frequency signal, and transmit a filtered combined signal to the analog-digital converter;
the analog-digital converter is configured to convert filtered combined signal into a digital signal, obtaining the combined signal after the conversion processing.

9. The device according to claim 6, wherein, the power divider is configured to divide the radio frequency signal into N paths of same radio frequency signal, wherein N is an integer greater than 1.

10. The device according to claim 6, wherein, the baseband signal conversion circuit comprises: a digital-to-analogue converter and a modulator, wherein:
the digital-to-analogue converter is configured to perform digital-to-analogue conversion on the baseband signal after the digital predistortion processing to obtain an analog signal, and transmit the analog signal to the modulator;
the modulator is configured to modulate the analog signal into a radio frequency signal through orthogonal modulation.

## Patentansprüche

1. Verfahren zur Verarbeitung einer digitalen Vorverzerrung, umfassend:
Durchführen einer Verarbeitung einer digitalen Vorverzerrung an einem Basisbandsignal gemäß einem ersten Vorverzerrungs-Korrekturparameter, Umwandeln des Basisbandsignals nach der Verarbeitung der digitalen Vorverzerrung in ein Funkfrequenzsignal, Leistungs-Teilen des Funkfrequenzsignals und jeweiliges Ausgeben jedes Pfads des Funkfrequenzsignals an einen eigenen Leistungsverstärker;
Koppeln und Ausgeben des von jedem Leistungsverstärker ausgegebenen Funkfrequenzsignals an eine Rückkopplungsverbindung zur Kombination, um ein kombiniertes Signal zu erhalten und Durchführen einer Umwandlungsverarbeitung an dem kombinierten Signal; und
Erzeugen eines zweiten Vorverzerrungs-Korrekturparameters gemäß dem kombinierten Signal nach der Umwandlungsverarbeitung und dem Basisbandsignal vor der Verarbeitung der digitalen Vorverzerrung und Aktualisieren des ersten Vorverzerrungs-Korrekturparameters als den zweiten Vorverzerrungs-Korrekturparameter.

2. Verfahren gemäß Anspruch 1, wobei der Schritt des Erzeugens eines zweiten Vorverzerrungs-Korrekturparameters gemäß dem kombinierten Signal nach der Umwandlungsverarbeitung und dem Basisbandsignal vor der Verarbeitung der digitalen Vorverzerrung umfasst:
Verarbeiten des kombinierten Signals und des Basisbandsignals vor der Verarbeitung der digitalen Vorverzerrung, um Unterschiede zwischen dem kombinierten Signal und dem Basisbandsignal hinsichtlich Verzögerung, Amplitudenphase, Energie und Frequenz-Offset zu eliminieren, und Erhalten eines ausgerichteten kombinierten Signals und des Basisbandsignals vor der Verarbeitung der digitalen Vorverzerrung;
Durchführen einer Vergleichsrechnung an dem ausgerichteten kombinierten Signal und dem Basisbandsignal vor der Verarbeitung der digitalen Vorverzerrung, um den zweiten Vorverzerrungs-Korrekturparameter zu erhalten.

3. Verfahren gemäß Anspruch 1, wobei der Schritt des Durchführens der Umwandlungsverarbeitung an dem kombinierten Signal umfasst:
Herunterkonvertieren des kombinierten Signals in ein Mittelfrequenzsignal und Filtern des Mittelfrequenzsignals und Umwandeln des gefilterten kombinierten Signals in ein Digitalsignal, Erhalten des kombinierten Signals nach der Umwandlungsverarbeitung.

4. Verfahren gemäß Anspruch 1, wobei der Schritt des Teilens des Funkfrequenzsignals umfasst:
Teilen des Funkfrequenzsignals in N Pfade desselben Funkfrequenzsignals unter Verwendung eines Leistungsteilers, wobei N eine ganze Zahl größer als 1 ist.

5. Verfahren gemäß Anspruch 1, wobei der Schritt des Umwandelns des Basisbandsignals in ein Funkfrequenzsignal umfasst:
Durchführen einer Digital-Analog-Wandlung an dem Basisbandsignal nach der Verarbeitung der digitalen Vorverzerrung, um ein analoges Signal zu erhalten und Modulieren des analogen Signals in ein Funkfrequenzsignal durch orthogonale Modulation.

6. Vorrichtung zur Verarbeitung einer digitalen Vorverzerrung, umfassend:
einen Prozessor für eine digitale Vorverzerrung, eine Basisbandsignal-Umwandlungsschaltung, einen Leistungsteiler, einen Leistungsverstärker, einen Kombinierer, eine Verarbeitungsschaltung für ein kombiniertes Signal und eine Trainingsvorrichtung für eine digitale Vorverzerrung, wobei:
der Prozessor für eine digitale Vorverzerrung konfiguriert ist, um eine Verarbeitung einer digitalen Vorverzerrung an einem Basisbandsignal gemäß einem ersten Vorverzerrungs-Korrekturparameter durchzuführen und das Basisbandsignal nach der Verarbeitung der digitalen Vorverzerrung an die Basisbandsignal-Umwandlungsschaltung zu übertragen;
die Basisbandsignal-Umwandlungsschaltung konfiguriert ist, um das Basisbandsignal nach der Verarbeitung der digitalen Vorverzerrung in ein Funkfrequenzsignal umzuwandeln und das Funkfrequenzsignal an den Leistungsteiler zu übertragen;
der Leistungsteiler konfiguriert ist, um das Funkfrequenzsignal zu teilen und jeweils jeden Pfad des Funkfrequenzsignals an einen eigenen Leistungsverstärker zu übertragen;
der Kombinierer konfiguriert ist, um das von jedem Leistungsverstärker ausgegebene Funkfrequenzsignal zu koppeln und auszugeben an eine Rückkopplungsverbindung zur Kombination, um ein kombiniertes Signal zu erhalten, und das kombinierte Signal an die Verarbeitungsschaltung für ein kombiniertes Signal zu übertragen;
die Verarbeitungsschaltung für ein kombiniertes Signal konfiguriert ist, um eine Umwandlungsverarbeitung an dem kombinierten Signal durchzuführen und das kombinierte Signal nach der Umwandlungsverarbeitung an die Trainingsvorrichtung für eine digitale Vorverzerrung zu übertragen;
die Trainingsvorrichtung für eine digitale Vorverzerrung konfiguriert ist, um einen zweiten Vorverzerrungs-Korrekturparameter gemäß dem kombinierten Signal nach der Umwandlungsverarbeitung und dem Basisbandsignal vor der Verarbeitung der digitalen Vorverzerrung zu erzeugen und den zweiten Vorverzerrungs-Korrekturparameter an den Prozessor für eine digitale Vorverzerrung zu aktualisieren.

7. Vorrichtung gemäß Anspruch 6, wobei die Trainingsvorrichtung für eine digitale Vorverzerrung umfasst:
ein Datensammelmodul, ein Datenverarbeitungsmodul, ein Extraktionsmodul für einen Vorverzerrungs-Korrekturparameter und ein Parameter-Aktualisierungsmodul, wobei:
das Datensammelmodul konfiguriert ist, um das kombinierte Signal und das Basisbandsignal vor der Verarbeitung der digitalen Vorverzerrung zu sammeln;
das Datenverarbeitungsmodul konfiguriert ist, um das kombinierte Signal und das Basisbandsignal vor der Verarbeitung der digitalen Vorverzerrung zu verarbeiten, um Unterschiede zwischen dem kombinierten Signal und dem Basisbandsignal hinsichtlich Verzögerung, Amplitudenphase, Energie und Frequenz-Offset zu eliminieren, und ein ausgerichtetes kombiniertes Signal und das Basisbandsignal vor der Verarbeitung der digitalen Vorverzerrung zu erhalten;
das Extraktionsmodul für einen Vorverzerrungs-Korrekturparameter konfiguriert ist, um eine Vergleichsrechnung an dem ausgerichteten kombinierten Signal und dem Basisbandsignal vor der Verarbeitung der digitalen Vorverzerrung durchzuführen, um den zweiten Vorverzerrungs-Korrekturparameter zu erzeugen;
das Parameter-Aktualisierungsmodul konfiguriert ist, um den zweiten Vorverzerrungs-Korrekturparameter an den Prozessor für eine digitale Vorverzerrung zu aktualisieren.

8. Vorrichtung gemäß Anspruch 6, wobei die Verarbeitungsschaltung für ein kombiniertes Signal umfasst: einen Mischer, ein Filter und einen Analog-Digital-Wandler, wobei:
der Mischer konfiguriert ist, um das kombinierte Signal in ein Mittelfrequenzsignal herunterzukonvertieren und das Mittelfrequenzsignal an das Filter zu übertragen;
das Filter konfiguriert ist, um das Mittelfrequenzsignal zu filtern und ein gefiltertes kombiniertes Signal an den Analog-Digital-Wandler zu übertragen;
der Analog-Digital-Wandler konfiguriert ist, um das gefilterte kombinierte Signal in ein digitales Signal umzuwandeln und das kombinierte Signal nach der Umwandlungsverarbeitung zu erhalten.

9. Vorrichtung gemäß Anspruch 6, wobei der Leistungsteiler konfiguriert ist, um das Funkfrequenzsignal in N Pfade desselben Funkfrequenzsignals zu teilen, wobei N eine ganze Zahl größer als 1 ist.

10. Vorrichtung gemäß Anspruch 6, wobei die Basisbandsignal-Umwandlungsschaltung umfasst:
einen Digital-Analog-Wandler und einen Modulator, wobei:
der Digital-Analog-Wandler konfiguriert ist, um eine Digital-Analog-Wandlung an dem Basisbandsignal nach der Verarbeitung der digitalen Vorverzerrung durchzuführen, um ein analoges Signal zu erhalten, und das analoge Signal an den Modulator zu übertragen;
der Modulator konfiguriert ist, um das analoge Signal in ein Funkfrequenzsignal durch orthogonale Modulation zu modulieren.

## Revendications

1. Procédé de traitement de pré-distorsion numérique, comprenant les étapes consistant à :
effectuer un traitement de pré-distorsion numérique sur un signal de bande de base en fonction d'un premier paramètre de correction de pré-distorsion, convertir le signal de bande de base après le traitement de pré-distorsion numérique en un signal de fréquence radio, diviser la puissance du signal de fréquence radio, et délivrer en sortie respectivement chaque trajet du signal de fréquence radio à un amplificateur de puissance distinct ;
coupler et délivrer en sortie le signal de fréquence radio délivré en sortie par chaque amplificateur de puissance avec une liaison de retour pour une combinaison afin d'obtenir un signal combiné, et effectuer un traitement de conversion du signal combiné ; et
générer un second paramètre de correction de pré-distorsion en fonction du signal combiné après le traitement de conversion et le signal de bande de base avant le traitement de pré-distorsion numérique, et mettre à jour le premier paramètre de correction de pré-distorsion en tant que second paramètre de correction de pré-distorsion.

2. Procédé selon la revendication 1, dans lequel l'étape consistant à générer un second paramètre de correction de pré-distorsion en fonction du signal combiné après le traitement de conversion et le signal de bande de base avant le traitement de pré-distorsion numérique comprend les étapes consistant à :
traiter le signal combiné et le signal de bande de base avant le traitement de pré-distorsion numérique pour éliminer les différences entre le signal combiné et le signal de bande de base en retard, en phase d'amplitude, en énergie et en décalage de fréquence, et obtenir un signal combiné aligné et le signal de bande de base avant le traitement de pré-distorsion numérique ;
effectuer un calcul de comparaison sur le signal combiné aligné et le signal de bande de base avant le traitement de pré-distorsion numérique pour obtenir le second paramètre de correction de pré-distorsion.

3. Procédé selon la revendication 1, dans lequel, l'étape consistant à effectuer un traitement de conversion sur le signal combiné comprend les étapes consistant à :
convertir en abaissant en fréquence le signal combiné en un signal de moyenne fréquence, et filtrer le signal de moyenne fréquence, et convertir un signal combiné filtré en un signal numérique, pour obtenir le signal combiné après le traitement de conversion.

4. Procédé selon la revendication 1, dans lequel, l'étape consistant à diviser le signal de fréquence radio comprend l'étape consistant à :
diviser le signal de fréquence radio en N trajets de signal de même fréquence radio en utilisant un diviseur de puissance, dans lequel N est un entier supérieur à 1.

5. Procédé selon la revendication 1, dans lequel, l'étape consistant à convertir le signal de bande de base en un signal de fréquence radio comprend les étapes consistant à :
effectuer une conversion numérique-analogique sur le signal de bande de base après le traitement de pré-distorsion numérique pour obtenir un signal analogique, et moduler le signal analogique en un signal de fréquence radio au moyen d'une modulation orthogonale.

6. Dispositif de traitement de pré-distorsion numérique, comprenant : un processeur de pré-distorsion numérique, un circuit de conversion de signal de bande de base, un diviseur de puissance, un amplificateur de puissance, un combinateur, un circuit de traitement de signal combiné et un dispositif d'apprentissage de pré-distorsion numérique, dans lequel :
le processeur de pré-distorsion numérique est configuré pour effectuer un traitement de pré-distorsion numérique sur un signal de bande de base en fonction d'un premier paramètre de correction de pré-distorsion, et transmettre le signal de bande de base après le traitement de pré-distorsion numérique au circuit de conversion de signal de bande de base ;
le circuit de conversion de signal de bande de base est configuré pour convertir le signal de bande de base après le traitement de pré-distorsion numérique en un signal de fréquence radio, et émettre le signal de fréquence radio vers le diviseur de puissance ;
le diviseur de puissance est configuré pour diviser le signal de fréquence radio, et transmettre respectivement chaque trajet de signal de fréquence radio à un amplificateur de puissance distinct ;
le combineur est configuré pour coupler et délivrer en sortie le signal de fréquence radio délivré en sortie par chaque amplificateur de puissance avec une liaison de retour pour une combinaison afin d'obtenir un signal combiné, et transmettre le signal combiné au circuit combiné de traitement de signal ;
le circuit combiné de traitement de signaux est configuré pour effectuer un traitement de conversion du signal combiné, et transmettre le signal combiné après le traitement de conversion au dispositif d'apprentissage de pré-distorsion numérique ;
le dispositif d'apprentissage de pré-distorsion numérique est configuré pour générer un second paramètre de correction de pré-distorsion en fonction du signal combiné après le traitement de conversion et le signal de bande de base avant le traitement de pré-distorsion numérique, et mettre à jour le second paramètre de correction de pré-distorsion pour le processeur de pré-distorsion numérique.

7. Dispositif selon la revendication 6, dans lequel le dispositif d'apprentissage de pré-distorsion numérique comprend : un module de collecte de données, un module de traitement de données, un module d'extraction de paramètres de correction de pré-distorsion et un module de mise à jour de paramètres, dans lequel :
le module de collecte de données est configuré pour collecter le signal combiné et le signal de bande de base avant le traitement de pré-distorsion numérique ;
le module de traitement de données est configuré pour traiter le signal combiné et le signal de bande de base avant le traitement de pré-distorsion numérique pour éliminer les différences entre le signal combiné et le signal de bande de base en retard, en phase d'amplitude, en énergie et en décalage de fréquence, et pour obtenir un signal combiné aligné et le signal de bande de base avant le traitement de pré-distorsion numérique ;
le module d'extraction de paramètres de correction de pré-distorsion est configuré pour effectuer un calcul de comparaison sur le signal combiné aligné et sur le signal de bande de base avant le traitement de pré-distorsion numérique pour générer le second paramètre de correction de pré-distorsion ;
le module de mise à jour de paramètres est configuré pour mettre à jour le second paramètre de correction de pré-distorsion pour le processeur de pré-distorsion numérique.

8. Dispositif selon la revendication 6, dans lequel, le circuit de traitement de signal combiné comprend : un mélangeur, un filtre et un convertisseur analogique-numérique, dans lequel :
le mélangeur est configuré pour convertir en abaissant en fréquence le signal combiné en un signal de moyenne fréquence, et transmettre le signal de moyenne fréquence au filtre ;
le filtre est configuré pour filtrer le signal de moyenne fréquence, et transmettre un signal combiné filtré au convertisseur analogique-numérique ;
le convertisseur analogique-numérique est configuré pour convertir le signal combiné filtré en un signal numérique, pour obtenir le signal combiné après le traitement de conversion.

9. Dispositif selon la revendication 6, dans lequel le diviseur de puissance est configuré pour diviser le signal de fréquence radio en N trajets de signal de même fréquence radio, dans lequel N est un entier supérieur à 1.

10. Dispositif selon la revendication 6, dans lequel le circuit de conversion de signal de bande de base comprend : un convertisseur numérique-analogique et un modulateur, dans lequel :
le convertisseur numérique-analogique est configuré pour effectuer une conversion numérique-analogique sur le signal de bande de base après le traitement de pré-distorsion numérique pour obtenir un signal analogique et transmettre le signal analogique au modulateur ;
le modulateur est configuré pour moduler le signal analogique en un signal de fréquence radio au moyen d'une modulation orthogonale.
